**Europäisches Patentamt**

(19) **European Patent Office**

**Office européen des brevets**

(11) Veröffentlichungsnummer: **0 123 278**

**B1**

(12) **EUROPÄISCHE PATENTSCHRIFT**

(45) Veröffentlichungstag der Patentschrift:
12.08.87

(21) Anmeldenummer: **84104428.2**

(22) Anmeldetag: **18.04.84**

(51) Int. Cl.⁴: **H 03 H 17/02**

(54) **Wellendigitalfilter unter Verwendung von Brückenwellendigitalfiltern.**

(30) Priorität: **22.04.83 DE 3314647**

(43) Veröffentlichungstag der Anmeldung:
**31.10.84 Patentblatt 84/44**

(45) Bekanntmachung des Hinweises auf die Patenterteilung:
**12.08.87 Patentblatt 87/33**

(84) Benannte Vertragsstaaten:
**DE FR IT**

(56) Entgegenhaltungen:
**EP-A-0 063 274**

**1982 INTERNATIONAL SYMPOSIUM ON CIRCUITS AND SYSTEMS, Rome, 10.-12. Mai 1982, Seiten 264-267, IEEE, New York, USA; J.A. NOSSEK et al.: "Efficient sampling rate increase and decrease in wave digital filters with applications in communication systems"**

(73) Patentinhaber: **Siemens Aktiengesellschaft Berlin und München, Wittelsbacherplatz 2, D-8000 München 2 (DE)**

(72) Erfinder: **Nossek, Josef, Dr., Waldstrasse 17, D-8127 Iffeldorf (DE)**

EP 0 123 278 B1

# 0 123 278

**Beschreibung**

Die Erfindung betrifft eine Wellendigitalfilter unter Verwendung von Brückenwellendigitalfiltern, deren Referenzfilter eine selbstreziproke charakteristische Funktion aufweisen.

Bekanntlich sind zur Lösung einer Reihe nachrichtentechnischer Probleme Schaltungen erforderlich, die die sogenannte Nyquist-Bedingung erfüllen. Diese Bedingung ist definiert, zugehörige Schaltungen werden beispielsweise dann gebraucht, wenn es darauf ankommt, Impulse intersymbolstörungsfrei (d.h. ohne Impulsnebensprechen) zu übertragen bzw. Videofrequenzbänder umzusetzen und dabei die Frequenz Null und ein Restseitenband noch übertragen werden muß, Selektionsmittel zur Lösung solcher Aufgaben stehen ebenfalls zur Verfügung. In der Deutschen Patentschrift DE-C- 22 41 159 bzw. in einem Aufsatz in der Zeitschrift "Frequenz", 1973, Band 27, Seiten 2 bis 6, werden für die Verarbeitung analoger Signale Möglichkeiten zur Synthese von Nyquist-Filtern angegeben. Im Grundkonzept laufen diese Schaltungen darauf hinaus, sogenannte strenge Frequenzweichen zu realisieren, bei denen Filter mit einer sogenannten selbstreziproken charakteristischen Funktion verwendet sind. Inzwischen wird auch die sogenannte digitale Technik bei Nachrichtenübermittlungssystemen eingesetzt und es steht somit auch das Problem an, hierfür Selektionsmittel zu schaffen, Schaltungen und Netzwerke also, für die sich der Ausdruck "digitale Filter" eingebürgert hat. Eine spezielle Gattung dieser digitalen Filter sind die sogenannten Wellendigitalfilter. Solche Schaltungen sind beispielsweise in der Deutschen Patentschrift DE-C- 20 27 303 bzw. in der Zeitschrift "AEÜ", Band 25 (1971) Seiten 79 bis 89 beschrieben. Wellendigitalfilter haben den Vorteil, daß analoge Referenzfilter unmittelbar digital nachgebildet werden können. In der Zeitschrift "AEÜ" 1979, Seiten 239 bis 243 sind schließlich Wellendigitalfilter der eingangs genannten Art angegeben, bei denen also Brückenwellendigitalfilter verwendet sind und bei denen die Zahl der Multiplizierer und Addierer möglichst vermindert werden soll.

Der Erfindung liegt die Aufgabe zugrunde, Wellendigitalfilter der eingangs genannten Art anzugeben, bei denen die Nyquist-Bedingungen hinsichtlich Amplitude und Phase auch schaltungstechnisch durchaus erfüllbar sind.

Ausgehend von Wellendigitalfiltern der einleitend genannten Art wird diese Aufgabe gemäß der Erfindung nach den kennzeichnenden Merkmalen des Patentanspruches 1 gelöst.

Vorteilhafte Ausgestaltungen sind in den Unteransprüchen angegeben.

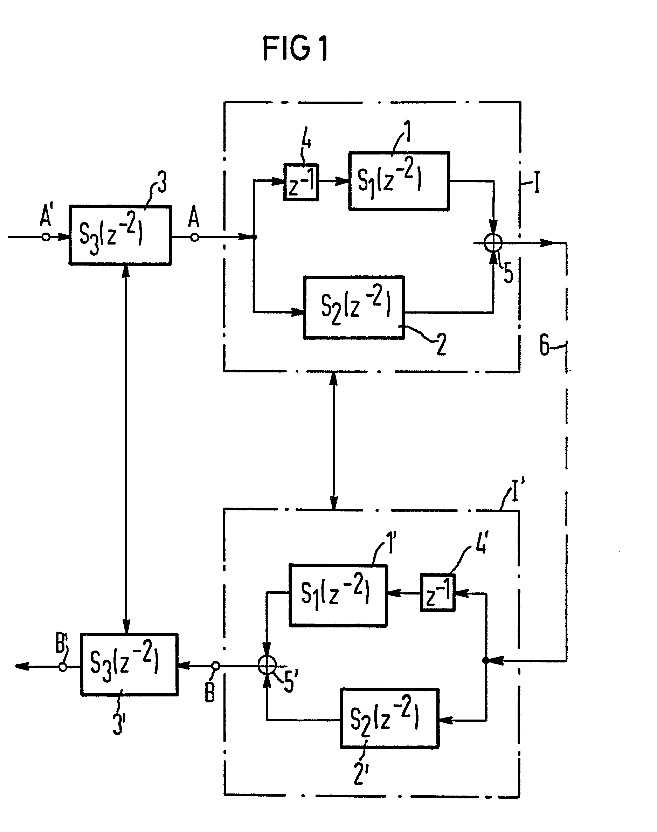

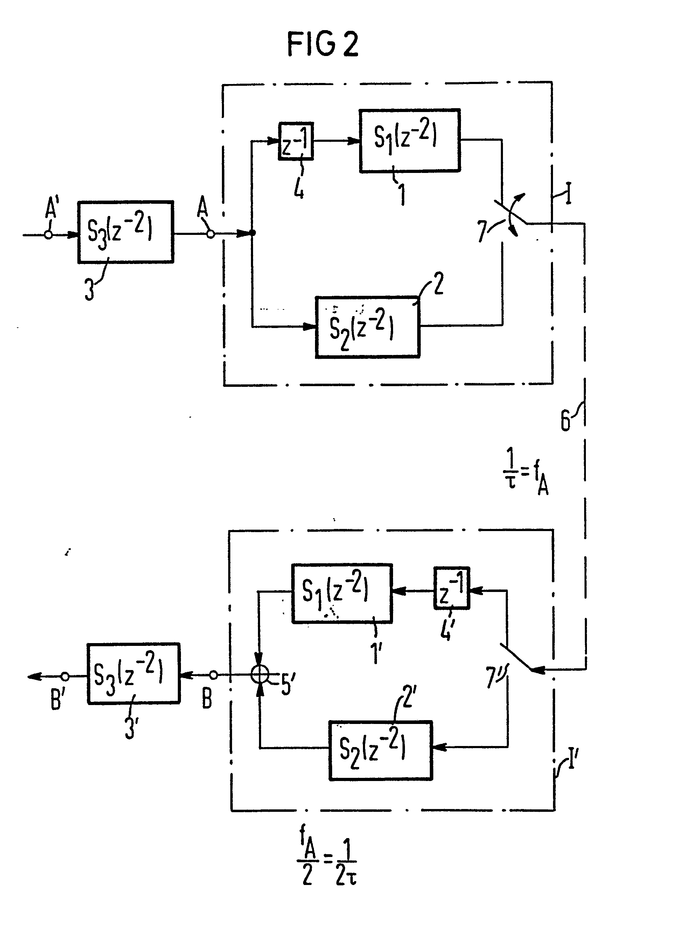

Anhand der beigefügten Figuren 1 und 2 wird nachstehend die Erfindung noch näher erläutert.

Es zeigen in der Zeichnung

Fig. 1 das Blockschaltbild einer erfindungsgemäßen Anordnung,

Fig. 2 Möglichkeiten zur Verwendung eines Interpolators bzw. eines Dezimators, wobei die Wellendigitalfilter-Allpässe insbesondere auf der Seite mit der niedrigeren Abtastrate liegen.

In der Fig. 1 ist mit der Bezugsziffer I eine digitale Schaltungseinheit gekennzeichnet, wie sie in dem eingangs genannten Aufsatz 1979, Seiten 239 bis 243 bereits beschrieben ist. Die einzelnen Bausteine sind Allpässe (1, 2, 4 bzw. 1', 2', 4') und bilden Brückenwellendigitalfilter, deren Referenzfilter eine selbstreziproke charakteristische Funktion haben. Bekanntlich sind die sogenannten Referenzfilter solche Filter, die der Berechnung der gesamten Filteranordnung zugrunde gelegt werden. In dem einen Zweig ist also ein Filter 1 mit der Übertragungsfunktion $S_1$ $(z^{-2})$ der eine Schaltung 4 mit der Verzögerung $z^{-1}$ vorgeschaltet ist. Im zweiten Zweig liegt die Schaltung 2, mit der Übertragungsfunktion $S_2$ $(z^{-2})$ und es werden diese beiden Zweige über den Addierer 5 miteinander verknüpft. Die eingetragenen Pfeile und auch das Additionszeichen lassen unmittelbar die Übertragungsrichtung erkennen. Über die ebenfalls symbolisch dargestellte Leitung 6 ist eine Schaltungsanordnung I' angeschaltet, sodaß also die Anordnungen I und I' unmittelbar in Kette geschaltet sind. Wie der Figur ohne weiteres zu entnehmen ist, sind die Schaltungseinheiten I und I' identisch, was im Beispiel lediglich durch eine Apostrophierung kenntlich gemacht wird. Aus diesem Grund ist in der Schaltungsanordnung I' im einen Zweig ein Filter 1' und ein Verzögerer 4' in Kette geschaltet, parallel dazu ist die Schaltung 2' zu erkennen und es haben die Schaltungen 1', 2' und 4' die gleichen Übertragungsfunktionen wie die Schaltungen 1, 2 und 4. Es folgt dann der Addierer 5', von dem aus der Ausgang der Schaltung erreicht wird. Der Eingang der Schaltung I ist mit A bezeichnet, der Ausgang der Schaltung I' ist mit B bezeichnet. Zwischen den Punken A und B wird die Nyquist-Amplitudenbedingung exakt erfüllt. Wie sich zeigt, läßt sich auch die komplexe Nyquist-Bedingung, also die Nyquist-Bedingung hinsichtlich der Amplitude und einer linearen Phase dann erfüllen, wenn noch zwei zusätzliche Wellendigitalfilter-Allpässe zur Phasenlinearisierung vorgesehen sind. Diese beiden Allpässe sind in Fig. 1 mit Bezugsziffer 3 und 3' versehen und sie haben jeweils die gleiche Übertragungsfunktion $S_3$ $(z^{-2})$. Der Eingang des Wellendigitalfilterallpasses 3 ist mit A' bezeichnet, der Ausgang des Wellendigitalfilter-Allpasses 3' ist mit B' bezeichnet. Zwischen den Punkten A' und B' wird also die komplexe Nyquist-Bedingung hinsichtlich der Amplitude exakt erfüllt, hinsichtlich der Phase mit guter Näherung. Im einzelnen wird dies später noch erläutert.

In der Fig. 2 ist unmittelbar das Anhand von Fig. 1 bereits Erläuterte wiederzuerkennen.

Es sind dort wirkungsgleiche Elemente mit der gleichen Bezugsziffer wie in Fig. 1 bezeichnet, sodaß hierauf im einzelnen nicht mehr eingegangen werden muß. Erwähnt sei noch, daß die Funktionen $S_3$, $S_1$ und $S_2$ Allpassfunktionen sind. Insbesondere ist in Fig. 2 durch die rotierenden Schalter 7 und 7' symbolisch kenntlich gemacht, daß die Brückenwellendigitalfilter I bzw. I' die Abtastraten um den Faktor 2 erhöhen bzw. absenken können. Die Operationen werden hierbei im Rhythmus der niedrigeren Abtastfrequenz ausgeführt. Die Abtastratenerhöhung erfolgt durch einen sogenannten Interpolator, die Abtastratenabsenkung durch einen

2

sogenannten Dezimator. Für die hohe Abtastrate ist dabei eine Abtastfrequenz $f_A = 1/\tau$ vorgesehen. Die niedrigere Abtastrate wird festgelegt durch die Gleichung $f_A/2 = 1/2\tau$.

Zur weiteren Erläuterung sei noch auf folgendes hingewiesen.

Diese spektrumformenden Tiefpässe bzw. Allpässe 1, 2, 3, 4 (1', 2', 3', 4') sind interpolierende (bzw. dezimierende) digitale Filter, deren Übertragungsfunktion die Bedingung

$$F^2(\omega_N + \Delta\omega) + F^2(\omega_N - \Delta\omega) = 1 \qquad (1)$$

mit $\Delta\omega \varepsilon [0,\omega_N]$ erfüllen (erste Nyquistbedingung).

Zerlegt man diese Forderung in zwei Bedingungen für Betrag und Phase

$$\left| F(\omega_N + \Delta\omega) \right|^2 + \left| F(\omega_N - \Delta\omega) \right|^2 = 1 \qquad (1a)$$

$$\angle F(\omega) = K\omega. \qquad (1b)$$

dann ist die Erfüllung von (1a) und (1b) offensichtlich hinreichend für (1) und damit für verschwindende Intersymbolstörung, jedoch nicht notwendig!

Die Übertragungsfunktion $F(\omega)$ ist als Funktion eines digitalen (zeitdiskreten) Filters eine periodische (transzendente) Funktion in $\omega$ bzw. $p = \sigma + j\omega$ (analytische Fortsetzung ins Komplexe).

Der Übergang zu rational gebrochener Funktion gelingt mit Hilfe der sogenannten z-Transformation und der sogenannten bilinearen Transformation

$$\psi = \frac{z-1}{z+1} = \tanh\frac{p\tau}{2}, \; z = e^{p\tau}$$

$$\mathrm{Im}\,(\psi) = \varphi = \tan\frac{\omega\tau}{2}.$$

Dabei ist $\tau$ die Abtastperiode am Ausgang des ersten Filters I. Damit läßt sich
$F(\omega) = \hat{F}(\varphi)$
als rational gebrochene Funktion in $\varphi$ (bzw. $\psi$) darstellen und das ganze Werkzeug der an sich bekannten Betriebsparametertheorie konventioneller Filter anwenden.

So gilt z.B:

$$\left| \frac{1}{\hat{F}(\varphi)} \right|^2 - \left| K(\varphi) \right|^2 = 1. \qquad (3)$$

$K(\varphi)$ ist die charakteristische Funktion.

Nun läßt sich zeigen, daß für den Fall

$$K(\psi) = \frac{1}{K(\frac{1}{\psi})}, \qquad (4)$$

d.h. daß $K(\psi)$ eine selbstreziproke Funktion ist, die Betragsbedingung (1a) exakt erfüllt ist:

$$\left| \overset{\wedge}{F}(\varphi_1) \right|^2 = \left| F(\omega_N + \Delta\omega) \right|^2 = \frac{1}{1+|K(\varphi_1)|^2}$$

$$\left| \overset{\wedge}{F}(\varphi_2) \right|^2 = \left| F(\omega_N - \Delta\omega) \right|^2 = \frac{1}{1+|K(\varphi_2)|^2}$$

$$\varphi_1 = \tan(\omega_N + \Delta\omega)T = \frac{\tan\omega_N T + \tan\Delta\omega T}{1 - \tan\omega_N T \cdot \tan\Delta\omega T} = \frac{1 + \tan\Delta\omega T}{1 - \tan\Delta\omega T}$$

$$\varphi_2 = \tan(\omega_N - \Delta\omega)T = \frac{1 - \tan\Delta\omega T}{1 + \tan\Delta\omega T} \implies \varphi_1\,\varphi_2 = 1.$$

$$\left| \overset{\wedge}{F}(\varphi_1) \right|^2 + \left| \overset{\wedge}{F}(\varphi_2) \right|^2 = \frac{1}{1+|K(\varphi_1)|^2} + \frac{1}{1+|K(\frac{1}{\varphi_1})|^2} =$$

$$= \frac{1}{1+|K(\varphi_1)|^2} + \frac{1}{1+\frac{1}{|K(\varphi_1)|^2}} =$$

$$= \frac{1}{1+|K(\varphi_1)|^2} + \frac{K(\varphi_1)^2}{1+|K(\varphi_1)|^2} \equiv 1.$$

Damit kann die Entwurfsaufgabe auf die Berechnung eines Filters mit selbstreziproker charakteristischer Funktion, das anschließend laufzeitentzerrt werden muß, zuruckgeführt werden.

Für einen Tiefpaß $\rho = 0{,}5$ und einer Sperrdämpfung von mehr als 30 dB reicht bereits ein Wellendigitalfilter vom Grad 3 mit nur einem Zweitoradapter und einem sehr einfachen Koeffizienten von 0,375, der mit Hilfe von nur einer Addition ($0{,}375 = 1/2 - 1/8$) realisiert werden kann.

Da ein solches Filter eine Gruppenlaufzeit aufweist, die symmetrisch um $\omega_N$ ist, reicht es aus, die Laufzeitentzerrer (Allpässe) mit $2\omega_N = \omega_s$ zu takten und sie den Tiefpäassen auf der Seite mit niedrigerer Taktfrequenz vor- bzw. nachzuschalten. Um die Laufzeit bzw. die Phase auf ein für geringe Intersymbolstörung erforderliches Maß zu entzerren, reicht ein Allpaß-Glied zweiten Grades.

## Patentansprüche

1. Wellendigitalfilter unter Verwendung von Brückenwellendigitalfiltern (1, 2, 4), deren Referenzfilter eine selbstreziproke charakteristische Funktion aufweisen, dadurch gekennzeichnet, daß zwei identische, in Kette geschaltete, gemeinsam die Nyquist-Amplitudenbedingung erfüllende Brückenwellendigitalfilter (I, I') vorgesehen sind, denen zur Erfüllung der Nyquist-Phasenbedingung zusätzliche Wellendigitalfilter-Allpässe (3, 3') in Kette zugeschaltet sind. (Fig. 1)

2. Wellendigitalfilter nach Anspruch 1, dadurch gekennzeichnet, daß die Brückenwellendigitalfilter (I, I') die Abtastraten um den Faktor 2 erhöhen (interpolieren) bzw. absenken (dezimieren) und daß die hierfür nötigen Operationen im Rhythmus der niedrigeren der beiden Abtastraten ausgeführt werden. (Fig. 2)

3. Wellendigitalfilter nach Anspruch 1 oder 2, dadurch gekennzeichnet, daß die Wellendigitalfilter-Allpässe (3, 3') jeweils auf der Seite mit der niedrigeren Abtastrate vorgesehen sind. (Fig. 2)

## Claims

1. A digital wave filter comprising bridged digital wave filters (1, 2, 4), the reference filters of which have a self-reciprocal, characteristic function, characterised in that two identical bridged digital wave filters (I, I') are provided which are connected in a cascade arrangement, commonly fulfill the Nyquist amplitude condition and are connected in a cascade arrangement to additional all-pass digital wave filters (3, 3') in order to fulfill the Nyquist phase condition (Fig. 1).

2. A digital wave filter as claimed in claim 1, <u>characterised in</u> that the bridged digital wave filters (I, I') increase (interpolate) and reduce (decimate) the sample rates by the factor 2 and that the operations necessary for this purpose are carried out with the timing of the lower of the two sampling rates. (Fig. 2).

3. A digital wave filter as claimed in claim 1 or 2, <u>characterised in</u> that the all-pass digital wave filters (3, 3,) are each located on the side with the lower sampling rate (Fig. 2).

## Revendications

1. Tiltre d'ondes numériques utilisant des filtres d'ondes numériques en pont (1, 2, 4), dont les filtres de référence possèdent une fonction caractéristique autoréciproque, caractérisé par le fait qu'il est prévu deux filtres d'ondes numériques en pont (I, I') identiques, montés en chaine et satisfaisant ensemble à la condition d'amplitude de Nyquist et auxquels sont reliés en chaine des filtres d'ondes numériques passe-tout (3, 3') pour satisfaire à la condition de phase de Nyquist. (Figure 1).

2. Filtre d'ondes numériques suivant la revendication 1, caractérisé par le fait que les filtres d'ondes numériques en pont (I, I') croissent (interpolent) ou abaissent (écrêtent) la vitesse d'échantillonnage du facteur 2 et que les opérations nécessaires à cet effet sont exécutées au rythme de la plus faible des deux vitesses d'échantillonnage (figure 2).

3. Filtre d'ondes numériques selon la revendication 1 ou 2, caractérisé en ce que les filtres d'ondes numériques passe-tout (3, 3') sont prévus respectivement sur le côté de la vitesse d'échantillonnage la plus faible (figure 2).

0 123 278

# FIG 1

1

FIG 2